# EUROPEAN PATENT SPECIFICATION

(11) **EP 3 460 575 B1**
(45) Date of publication and mention of the grant of the patent: **09.11.2022**
(21) Application number: 17192575.3
(22) Date of filing: 22.09.2017
(51) Int. Cl.: G03F 7/24, G03F 7/30

(54) **TREATMENT ASSEMBLY OF THE WATER-BASED LIQUID USED IN A WASHING STATION FOR FLEXOGRAPHIC PLATES**
BEHANDLUNGSANORDNUNG DER IN EINER WASCHSTATION FÜR FLEXODRUCKPLATTEN VERWENDETEN WASSERBASIERTEN FLÜSSIGKEIT
ENSEMBLE DE TRAITEMENT DE LIQUIDE À BASE D'EAU UTILISÉ DANS UNE STATION DE LAVAGE DE PLAQUES FLEXOGRAPHIQUES

(43) Date of publication of application: 27.03.2019
(73) Proprietor: SASU VIANORD ENGINEERING, 06510 Carros (FR)
(72) Inventor: DE CARIA, Riccardo, 20080 BASIGLIO (IT)
(74) Representative: De Bortoli, Tiziano

(56) References cited:
- EP-A1- 0 624 828
- EP-A1- 1 406 125
- CN-A- 105 130 032
- US-A- 5 828 923

## Description

### FIELD OF THE INVENTION

The present invention relates to the field of processes for preparing analog and/or digital printing plates for flexography. In particular, the present invention relates to an assembly for treating and recovering the water used for washing a flexographic plate. The invention also relates to a washing station of a station either uses or comprises said treatment assembly.

### PRIOR ART

Flexography is a direct rotary printing method which employs plates in relief made of photo-polymeric materials. The plates are flexible and soft, hence the name flexography. Such plates are inked and the print is obtained by means of direct deposition of the ink on the medium to be printed by virtue of a slight pressure exerted by a printing cylinder on which the plates are positioned.

Flexography is a high-speed printing process, capable of printing on many types of absorbing and non-absorbing materials. Some typical applications of flexographic printing are the making of paper and plastic bags, milk cartons, disposable cups and the like, but by virtue of the progress in printing quality, flexography is today also used for printing newspapers, for example, as well as packets and labels and for printing on plastic, films and acetate sheets, packing paper and on many other materials used for product packaging.

*"Digital flexography"* is a particular process of flexographic printing in which digital plates are used. In such plates, the photo-polymer is originally covered by a surface layer of material which prevents photo-exposure, such as for example a carbon or graphite layer. Such layer of material is etched so as to create the negative image of the print subject. Such step of etching is usually performed by means of a digital laser, controlled by a computer (hence the acronym CTP *"Computer To Plate"* used to indicate this step of the pre-printing process in the sector). The plate is then photo-exposed and the material not exposed to the light is eliminated by means of a washing operation performed at a washing station.

In particular, the plate is typically washed using solvent-based liquid which dissolves the monomer (or polymer). Alternatively, the washing liquid may be water-based. In all cases, the mechanical action of brushes, which act on the plate surface to promote the detachment of the monomer (or polymer) previously not exposed to light, is provided. In particular, in the case of washing with water-based liquid, a stronger mechanical action is required from the brushes because the water alone cannot dissolve the monomer or polymer, but only soften it.

In both cases, after a given number of processed plates, the washing liquid must be treated in order to recover the monomer (or polymer), separating it from the solvent base or from the water base.

For the solvent-based washing of the plates, the use of solvent-based liquid has been proven to be effective but regretfully accompanied by several drawbacks, the first of which relates to the release of volatile organic compounds (VOC). As known, these compounds are accompanied by a high degree of toxicity and their concentration must be constantly monitored so that the values are kept within the limits established by law.

Another drawback related to the use of solvent-base liquids is that the final user of the plates, i.e. the printer, is forced to outsource plate preparation. This to avoid accumulating large amounts of solvent in environments adjacent to printing zones. So, digital printing plates are nearly ever sold directly to printers, but instead are sold to companies which are involved only with preparing them. This aspect obviously translates into less profit for plate manufacturers.

Yet another drawback is related to the disposal of the solvent, which is very complicated in terms of environmental safety.

Given the disadvantages presented above, the use of a water-based liquid for washing flexographic plates is certainly preferable to the use of solvent-based liquid. Water is indeed much easier to manage and does not imply the release of volatile organic compounds.

However, it has been found that the use of water-based washing liquid is not very widespread due to the difficulties currently encountered in treating the liquid for separating the monomer (or polymer) part from the water part. Such treatment become necessary when the concentration of monomer (or polymer) exceeds a threshold, making the washing liquid ineffective for the purpose.

Normally, water-based liquid is treated according to two methods, the first of which includes the use of filters, which mechanically separate the monomer (or polymer) from the liquid part. Such filters however must be cleaned very frequently and this inevitably influences the downtime, and thus the productivity, of the washing station.

Alternatively, after having washed a given number of plates, the used liquid is replaced with other liquid. The used liquid is transferred to a treatment station, in which the monomer (or polymer) is separated from the water by means of a distillation process. Such process includes the evaporation and the successive condensation of the water which is collected in a container. The water is then reused as base for generating other washing liquid.

However, this second treatment method requires managing large amounts of water and at the same time using an operating unit capable of distilling high volumes of water relatively fast. This obviously translates into an increase of construction costs and management costs.

EP 0 624 828 A1 discloses a method and an apparatus for circulating an aqueous developer used for processing flexographic printing plates. The apparatus comprises a developing unit with a developing tank containing an aqueous developer in which a flexographic plate can be supported and washed with the aid of brushes. The aqueous developer containing the eluted resin detached from the plates is discharged from the developing tank of the developing unit and sent to a series of treatment units for removing the eluted resin from it. The treated or purified aqueous developer is then fed back again into the developing tank of the developing unit. In one embodiment, said treatment units comprise in sequence a flocculating unit comprising a flocculation reaction tank and a solid content concentration tank, a solid/liquid separation or filtrating unit and a pH-adjusting unit. The flocculation reaction tank, the solid contentment concentration tank and the filtrating unit are arranged relative to each other and to the developing tank of the developing unit so that the resin containing developer can overflow from one tank/unit to the subsequent one. The overflow from the developing tank to the flocculation reaction tank is controlled by means of a weir. In other embodiments, the flocculation reaction tank, the solid content concentration tank, and/or the pH-adjusting unit can be omitted and the respective functions can be carried out in a single unit/tank.

Given the considerations indicated above, it is the main task of the present invention to provide a new method for treating the water-based washing liquid which makes it possible to overcome the drawbacks of the prior art described above. In the scope of this task, it is a first object of the present invention to provide a washing station for flexographic plates comprising a treatment unit which promotes the separation of the monomer (or polymer) from the water without using mechanical filters. It is another object of the present invention to provide a washing station for flexographic plates comprising a treatment unit which makes it possible to effectively recover the water part contained in the washing liquid, whereby greatly reducing the liquid volumes to be managed. A not last object of the present invention is to provide a washing station for flexographic plates comprising a treatment unit which is reliable and easy to make at competitive costs.

### SUMMARY

The present invention relates to a washing station for washing flexographic plates with water-based washing liquid, comprising a chamber in which said plates are treated and brushing means for brushing said plates arranged in said chamber. The washing station also comprises a treatment unit for treating the water-based washing liquid used in a washing station of flexographic plates, wherein said washing liquid comprises some monomer or polymer detached from said plates during such washing. The treatment unit comprises a first tank for collecting said washing liquid to a predetermined minimum filling level, and in which said monomer or said polymer may surface following a resting condition kept for a predetermined interval of time.

The treatment unit also comprises a second tank for collecting said monomer or polymer surfaced in the first tank; such second tank comprises an inlet section arranged at a height lower than the minimum filling level predetermined for said first tank.

Said first tank and said second tank of the treatment unit are arranged outside the chamber in which said plates are treated.

The treatment unit also comprises barrier means movable between a closing position, in which said means prevent the communication between the two tanks, and an opening position for which the two tanks become communicating so that at least said monomer or polymer surfaced in the first tank can overflow into the second tank.

The washing station further comprises a hydraulic distribution line comprising at least one circulation pump which hydraulically connects said first tank of said treatment unit to hydraulic terminals inside said chamber, from which said washing liquid may exit.

More in general, the present invention relates to a method for treating water-based liquid in a washing station of flexographic plates comprising a chamber in which said plates are treated, wherein said method includes the steps of:
a) providing a first tank and a second tank outside said chamber for collecting said liquid, wherein said second tank comprises an inlet section;
b) arranging said second tank with respect to said first tank so that the inlet section of the first tank is at a height lower than a predetermined minimum filling level for the liquid in said first tank;
c) providing, between said tanks, barrier means configured to assume a closing position, after which said tanks are not communicating, and an opening position, after which the liquid volume, in said first tank, comprised between said height of said inlet section and said minimum level can overflow into said second tank;
d) filling the first tank with said washing liquid to be treated to reach said minimum filling level, wherein during such filling the barrier means are in closing position;
e) keeping, following said step d), the washing liquid in a resting condition for a first predetermined interval of time to allow the surfacing of the monomer or polymer contained in the washing liquid and the decanting of the water under the surfaced monomer or polymer;
f) displacing said barrier means in said opening position to allow the liquid volume in said second tank to overflow so that said monomer or polymer surfaced in step e) is collected in the second tank.

Preferably, the method according to the invention also comprises the steps of:
g) keeping the overflown liquid in the second tank in a resting condition for another predetermined interval of time to allow the surfacing of said monomer or polymer contained in said overflown liquid and the decanting of the respective water part under the surfaced monomer and polymer;
h) taking, from the second tank, a volume of said decanted water in step g) and pouring such volume back into the first tank, and
i) taking the residual mixture remaining in the second tank at the end of step h) and subjecting said residual mixture to a distillation process to separate the monomer or polymer and obtain distilled water.

### LIST OF FIGURES

Further features and advantages of the present invention will be more apparent from the following detailed description provided by way of non-limiting example and illustrated in the accompanying figures, in which:
- Figure 1 is a first diagrammatic view of a treatment assembly of a water-based washing liquid comprising a treatment unit according to the present invention;
- Figures 2, 3 and 4 are respectively a second view, a third view and a fourth view of the assembly of Figure 1, each of which relates to an operative step of the assembly itself;
- Figure 5 is a diagrammatic view of a washing station comprising the treatment assembly of Figure 1;
- Figure 6 is a diagrammatic view of a further washing station comprising a treatment assembly of Figure 1;
- Figures 7 and 8 are further diagrammatic views of possible alternative embodiments of a treatment unit according to the present invention.

The same reference numbers and letters in the figures refer to the same elements or components.

### DETAILED DESCRIPTION

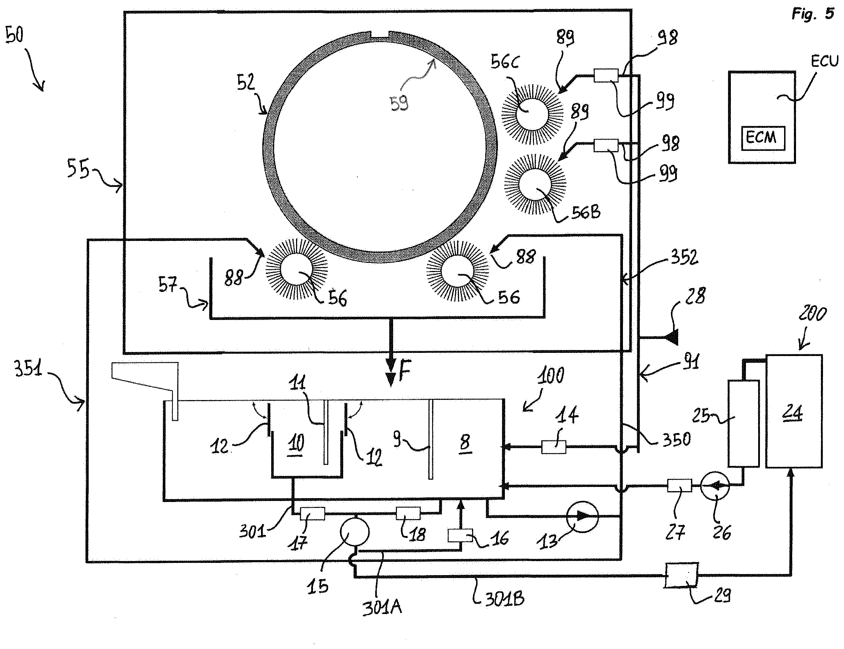

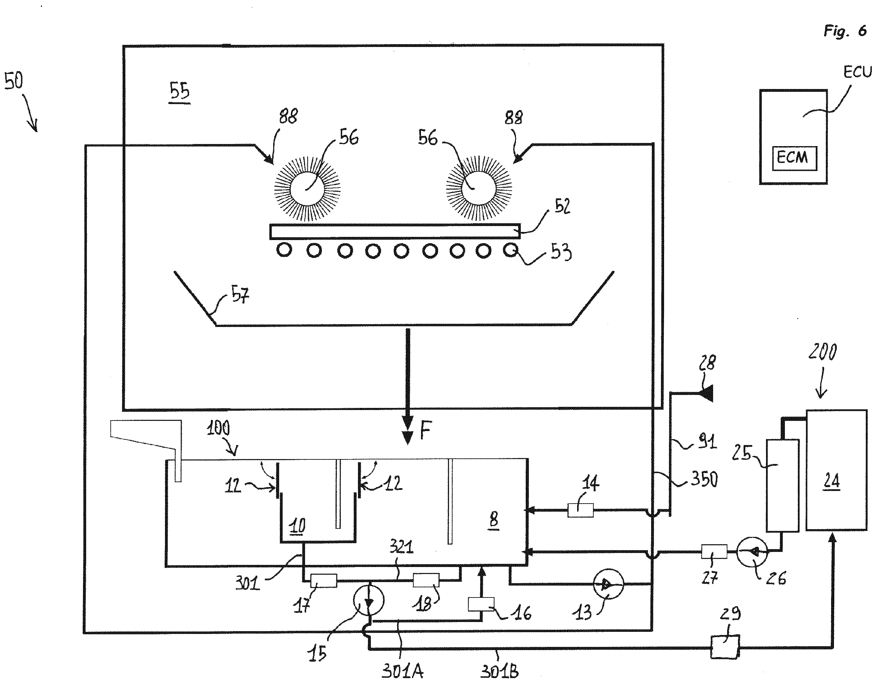

With reference to the mentioned figures, the present invention thus relates to a washing station for washing flexographic plates 52, comprising a treatment unit 100 of a water-based washing liquid used in the washing station. At the end of its use, such liquid is constituted of a mixture of water and of monomer (or polymer) detached from a plate 52 by effect of a mechanical brushing, according to a principle known in itself and in all cases reasserted below commenting Figures 5 and 6.

The treatment unit 100 comprises a first tank 8 for collecting the washing liquid. The first tank 8 is preferably arranged in position underneath a washing station 50, which comprises a chamber 55 in which a flexographic plate 52 is positioned. In such chamber 55 there are arranged means to brush the plate 52 and hydraulic terminals 88 allowing the washing liquid to enter into the chamber 55. The first tank 8 thus is a reservoir from where the liquid for washing the plate 52 is drawn. At the same time, the washing liquid, exiting from the chamber 55, may fall by gravity into the first tank 8 itself.

Alternatively, the first tank 8 could also be arranged in a remote position, i.e. in a position independent and separate from the washing station 50. In this case, the washing liquid could be transferred to the first tank 8 when its composition, in terms of water/monomer (or water/polymer) ratio, is such to require it to be treated. In all cases, once the liquid has been collected in the first tank 8, the monomer (or polymer) it contains may surface naturally by effect of its specific weight, which is lower than that of water. In this manner, after a given interval of time, in the first tank 8 it is possible to distinguish a first phase F1, mainly constituted of water, and a second phase F2, over the first phase F1, essentially constituted of water-soaked monomer (or polymer). The surfacing of the monomer (or polymer) is achieved by keeping the liquid in the first tank 8 in a resting condition, i.e. avoiding to agitate it or avoiding any operation on it, during said interval of time.

The treatment unit 100 also comprises a second tank 10 provided with an inlet section 10A. Such inlet section 10A, is arranged at a height H1 which is lower than a predetermined minimum filling level L1 which must be reached by the liquid in the first tank 8. Said minimum level L1 and the height H1 are determined with respect to a same substantially horizontal reference plane R1, which may coincide, for example, with the bottom wall 81 of the first tank 8.

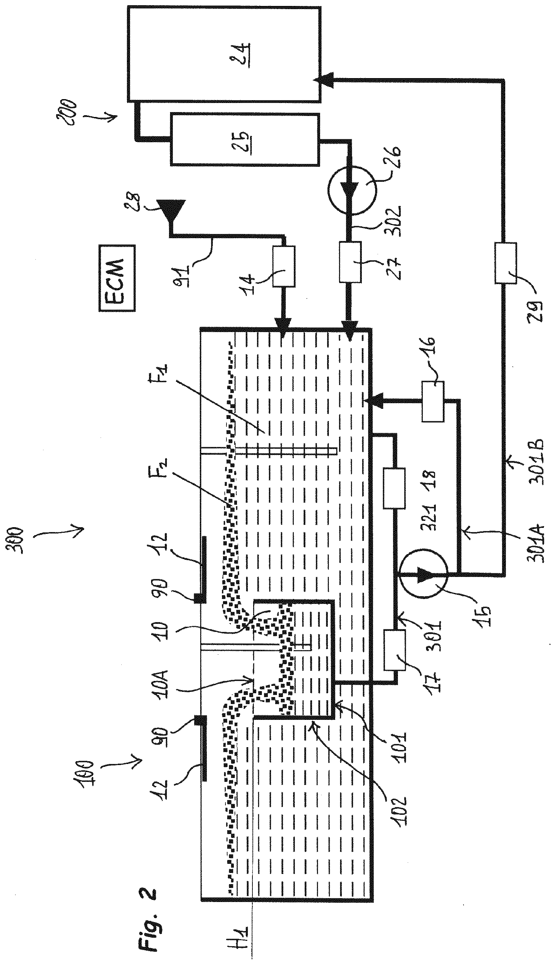

The treatment unit 100 comprises barrier means 12 (hereinafter named also only "barrier 12"), which are movable between a closing position and an opening position. In the closing position, such barrier means 12 mutually isolate the two tanks 8,10. In other words, in the closing position, the barrier means 12 prevent the communication between the first tank 8 and the second tank 10, i.e. prevent the liquid of the first tank 8 from entering into the second tank 10. Conversely, when the barrier 12 is in the opening position, the two tanks 8,10 become communicating so that the liquid part, containing the second phase F2 indicated above, can overflow into the second tank 10. The overflowing into the second tank 10 (diagrammatically shown in Figure 2) ends when the liquid level in the first tank 8 reaches the height H1 of the inlet section 10A of the second tank 10.

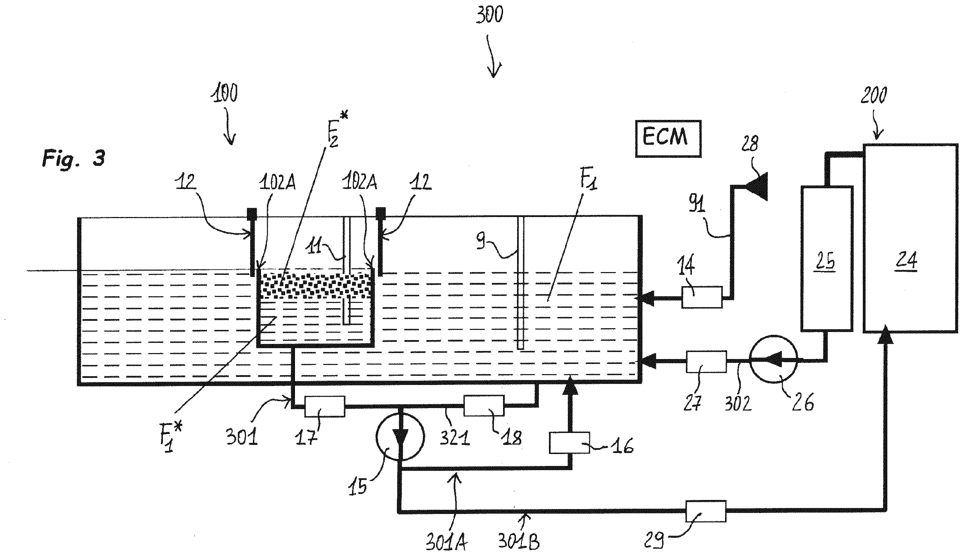

With reference to Figure 3, when the overflowing above is completed, the volume of liquid collected in the second tank 10 is lower than that contained in the first tank 8, in which all the second phase F2 comprising the monomer (or polymer) is advantageously contained, however. Substantially, the liquid initially contained in the first tank 8 is separated into two volumes: a greater first volume still contained in the first tank 8 and substantially constituted of only water (first phase F1), and a smaller second volume, contained in the second tank 10. Advantageously, only the second liquid volume will be later concerned by a process (preferably a distillation process) for separating the water part from the monomer (or polymer). However, since such second volume is much smaller than the first, the dimension/size of the unit used for such separation process may be smaller, with the advantage of cost reduction and easier management.

Figures from 1 to 3 diagrammatically illustrate a treatment assembly 300 of a water-based washing liquid comprising a treatment unit 100. The assembly 300 also comprises a distillation unit 200, known in itself. The first tank 8 of the treatment unit 100 comprises a bottom wall 81 and a side containing structure 82, which delimits a inner space in at least one portion of which the washing liquid coming from a washing station 50 is collected. Similarly, the second tank 10 also comprises a bottom wall 101 and a side containing structure 102. Needing to contain only the liquid volume which overflows following the opening of the barrier 12, the side structure 102 of the second tank 10 may delimit an inner volume which is smaller than that delimited by the side structure 82 of the first tank 8.

According to a preferred arrangement shown in Figures from 1 to 6, the second tank 10 is placed inside the inner space delimited by the side structure 82 of the first tank 8. Substantially, the space/volume delimited by the side structure 102 of the second tank 10 is inside that delimited by the side structure 82 of the first tank 8.

The bottom wall 101 of the second tank 10 may be arranged at a different height with respect to the bottom wall 81 of the first tank 8, as diagrammatically shown in the figures, but may have the same height.

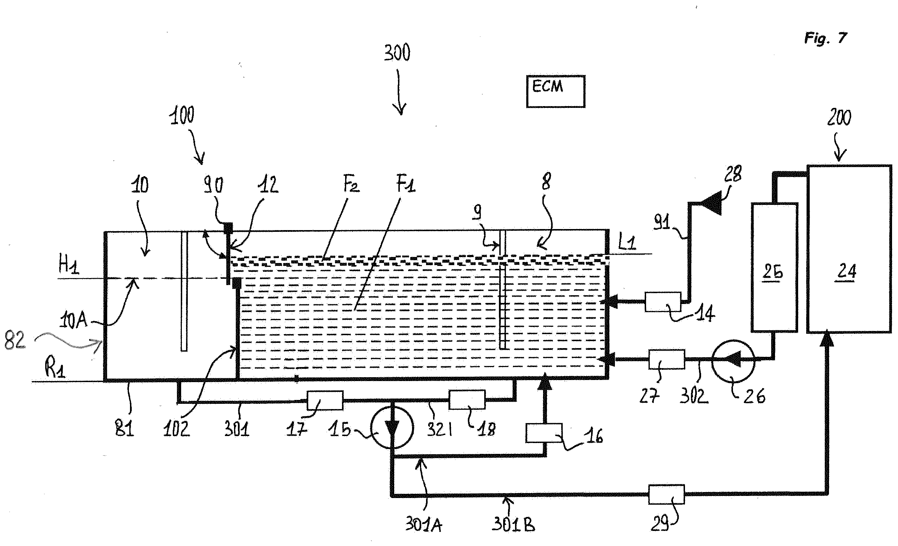

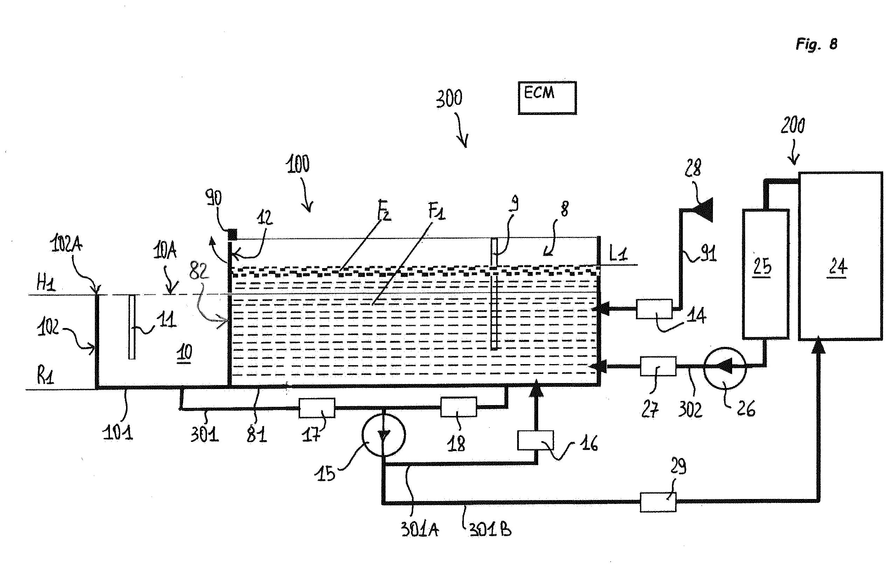

In an embodiment diagrammatically shown in Figure 7, the second tank 10 may be arranged outside and in a position adjacent to the first tank 8 (space/volume delimited by the side structure 102 of the second tank 10 external to the side structure 82 of the first tank 8). According to an embodiment, diagrammatically shown in Figure 8, the second tank 10 could be defined by a portion of the first tank 8. In this case, the bottom wall 101 of the second tank 10 could be defined by a bottom portion 81 of the first tank 8. At the same time, the inner volume of the second tank 10 could be partially defined by the side structure 82 of the first tank 8.

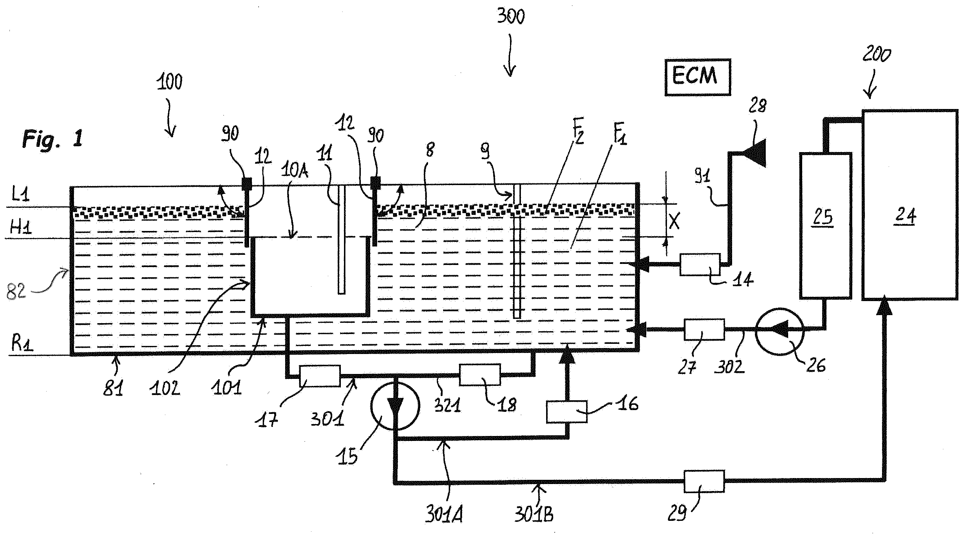

Preferably, the two tanks 8,10 are open on the top. In particular, in the second tank 10, the inlet section 10A is delimited by the upper edge 102A of the side containing structure 102. Preferably, at least one portion of such edge 102A develops on a substantially horizontal plane which defines the height H1 of the inlet section 10A. In figures 1-3, the inlet section 10A is shown by a dashed line of height H1 which develops between the opposite edges 102A of the side structure 102.

According to that shown above, the liquid in the first tank 8 is taken to a minimum predetermined level L1, which will be thus higher than height H1 in order to allow overflowing into the second tank 10. So, the liquid volume corresponding to the height X comprised between the minimum level L1 and height H1 can overflow into the second tank 10. Such height X may be easily established as a function of the volume of the second tank 10 and/or as a function of the height which concerns the second phase F2 described above.

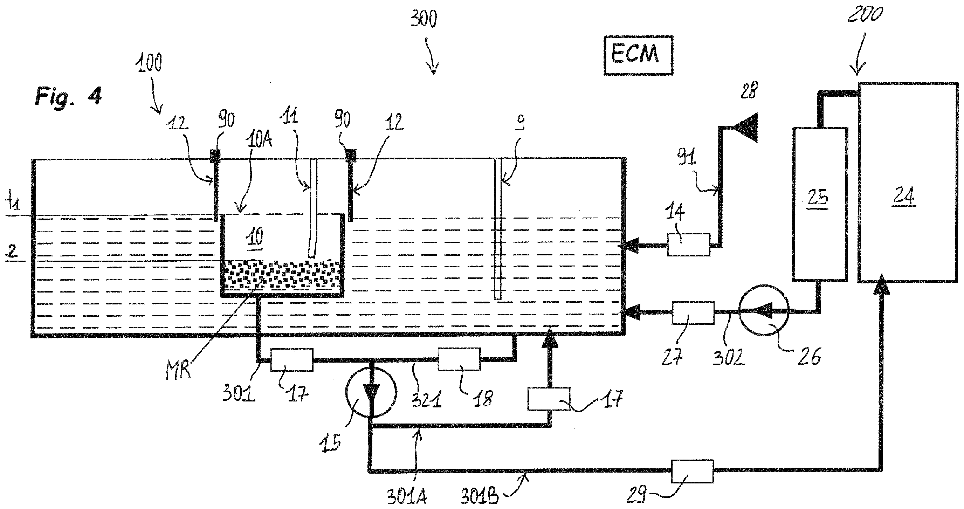

In the embodiment diagrammatically shown in Figures 1-4, the barrier means comprise two barriers 12 arranged at opposite sides of the second tank 10. In particular, such barriers 12 may turn, in reversible manner, between the closing position and the opening position. The word "reversible" indicates the possibility of moving from the closing position to the opening position, or vice versa from the opening position to the closing position. The rotation may be implemented manually by an operator or more preferably managed by a control module (hereinafter ECM). In this second case, rotation means 90 will be provided to turn the barriers 12 between the two indicated positions.

Alternatively, instead of rotating, the barriers 12 could be configured to translate, in reversible manner, from the closing position to the opening position. Preferably, also such translation may be automated by means of translation means controlled by an ECM. So, in general, movement means are provided to move said barrier means between the two positions defined above.

The position and the configuration of the barrier means may vary according to the configuration of the treatment unit 100, i.e. of the arrangement of the second tank 10 with respect to the first tank 8. In the configurations diagrammatically shown in figures 7 and 8, for example, there may be a single barrier 12, which can be rotated (or alternatively translated) between the closing position and the opening position, and vice versa.

In all cases, in the closing position, the barrier means constitute an extension of the corresponding side of the side structure 102 of the second tank 10 emerging over the corresponding edge 102A. In this manner, when each barrier 12 occupies the closing position, the liquid in the first tank 8 may be taken to a level higher than the height H1 identified by said edges 102A without any overflowing into the second tank 10. Instead, when the minimum level L1 is reached in the first tank 8, each barrier 12 can be opened to allow such overflowing.

Preferably, the treatment unit 100 comprises first sensor means 9, which detect the liquid level in the first tank 8. Even more preferably, the treatment unit 100 comprises a first hydraulic feeding line 91, which connects the first tank 10 to a running water source 28. An adjustment valve 14, preferably a solenoid valve electrically connected to the ECM, is arranged along such hydraulic line.

The first hydraulic feeding line 91 is used to feed the first tank 8 with running water, by opening the adjustment valve 14, if the liquid contained in the first tank is not sufficient to reach the minimum level L1 indicated above. In other words, the first hydraulic line 91 makes it possible to re-establish, in case of need, the ideal conditions to allow the correct overflowing into the second tank 10. In particular, it is worth noting that the water introduced with the first hydraulic feeding line 91 contributes to increasing the volume of the first phase F1 leaving the volume of the second phase F2 unchanged.

According to a preferred embodiment, the treatment unit 100 comprises a discharge line 301 for discharging the overflown liquid volume into the second tank 10 following the opening of the barrier means 12. Preferably, the discharge line 301 comprises a discharge valve 17, preferably a solenoid valve, which in an opening condition allows the liquid in the second tank 10 to exit. A first circulation pump 15 is arranged downstream of the discharge valve 17, instead.

Preferably, a first hydraulic branch 301A, which connects the discharge line 301, and thus the second tank 10, to the first tank 8, is arranged downstream of the first pump 15. A first shut-off valve 16, preferably a solenoid valve, is arranged along this first branch 301A. So, when the discharge valve 17 and the first shut-off valve 16 are open, the two tanks 8,10 communicate, and by effect of the first pump 15 a water part in the second tank 10 may be transferred into the first tank 8.

With this regard, as diagrammatically shown in Figure 3, after the liquid overflows into the second tank 10, it is left in a resting condition to allow the monomer (or polymer) to surface, similarly to that done in the first tank 8. Advantageously, after a given interval of time, also in the second tank 10 it will be possible to distinguish a first phase F1*, substantially constituted of water, and a second phase F2*, over the first phase F1*, constituted of surfaced water-soaked monomer (or polymer). Through the first hydraulic branch 301A, and following the opening of the discharge valve 17 and of the first shut-off valve 16, most of the water constituting the first phase F1* is advantageously returned to the first tank 8. In this manner, a first step of discharging is performed at the end of which only a residual mixture, comprising the second phase F2* and a very small amount of water, will remain in the second tank 10. The successive distillation process, by means of which the monomer (or polymer) is separated from the water, may be advantageously rapid precisely because of the small amount of water present in said residual mixture. Preferably, the first shut-off valve 16 keeps an opening condition until the liquid overflown into the second tank 8 drops under a second minimum level L2. With this regard, the treatment unit 100 preferably comprises second sensor means 11, which detect the liquid level, i.e. the quantity/volume thereof, in the second tank 10. Preferably, the second sensor means 11 and the first shut-off valve 16 are electrically connected to the control module ECM. The latter controls the opening/closing of the first shut-off valve 16 as a function of the liquid level in the second tank 10 detected by the second sensor means 11.

According to another aspect, a second hydraulic branch 301B is arranged downstream of the first pump 15, to connect the discharge line 301 to a distillation unit 200. In particular, the second branch 301B is used to make a second step of discharging, successive to the first step of discharging described above, so as to complete the emptying of the second tank 10.

Also developing downstream of the first circulation pump 15, the second branch 301B is hydraulically parallel to the first branch 301A. A second shut-off valve 29, which allows said residual mixture (pushed by the first pump 15) to either reach the distillation unit 200 or not, is arranged along the second branch 301B. Such second shut-off valve 29, thus remains closed during the first step of discharging of the tank 10, i.e. when the first shut-off valve 16 is open.

The second shut-off valve 29 is also preferably a solenoid valve electrically connected to the control module ECM which controls its activation/deactivation, i.e. its opening/closing, as a function of the liquid in the second tank 10 detected by the second sensor means 11. The module ECM keeps the second shut-off valve 29 open until the second tank 10 is empty, condition which can be detected, for example, again by means of the second sensor means 11.

The module ECM to which reference was made several times above is shown in Figures 1-4, 7 and 8. The electric connections by means of which the module ECM is connected to the various aforesaid components (barrier means, sensor means, valves, circulation pump etc.) are not shown for the sake of clarity of these Figures.

The distillation unit 200 may have a configuration known in itself, which includes a distillation module 24, configured to evaporate the water part, and a container 25, in which the distilled water is collected. Preferably, the first unit 100 or the treatment assembly 300, comprises a second hydraulic feeding line 302, which connects such container 25 with the first tank 8. A second circulation pump 26 and a further shut-off valve 27, both preferably controlled by the same control ECM, are arranged along such second hydraulic line 302. The distilled water is thus transferred in the first tank 8 following the actuation of the second pump 26 and the opening of the shut-off valve 27.

As a whole, the two treatment units 100,200 make it possible to recover the entire water part contained in the liquid volume which overflows into the second tank 10 following the opening of the barriers 12. A first fraction of this water is returned to the first tank 8 during the first step of discharging, i.e. through the first hydraulic branch 301A, while the remaining fraction is distilled in the distillation unit 300 and conveyed back into the first tank 8 through the second hydraulic line 302. According to another aspect visible in the figures, the treatment unit 100 comprises a second discharging line 321 which connects the first tank 8 to the first discharging line 301 upstream of the first circulation pump 15. A second discharging valve 18 which, in an opening condition allows the extraction, by pumping, of the liquid contained in the first tank 8, is located along the second discharging line 321. When the treatment unit 100 is integrated in a washing station 50, the second discharging line 321 makes it possible to transfer the liquid contained in the first tank 8 directly into the distillation unit 200, without the passage into the second tank 10. As will be described in greater detail below, this direct transfer is preferably actuated during a stop time (time of non-use) of the washing station 50, e.g. during the night. Substantially, during such period of time, the liquid is subjected to the distillation treatment so as to eliminate the monomer (or polymer). When the container 25 is full, the distilled water is returned to the first tank 8.

Given the above, in general, the present invention relates to a method for treating the water-based liquid used in a washing station of flexographic plates. In its essential embodiment, such method includes at least the steps of:
a) providing a first tank 8 and a second tank 10 outside the chamber 55 in which the plates 52 are treated, for collecting the liquid, wherein said second tank 10 comprises an inlet section 10A;
b) arranging the second tank 10 with respect to the first tank 8 so that its inlet section 10A is at a lower height H1 than a predetermined minimum filling level L1 for the washing liquid L1 in the first tank 8;
c) providing, between the tanks 8,10, barrier means 12 configured to assume a closing position, after which the tanks 8,10 are not communicating, and an opening position, after which the liquid volume of said first tank 8 comprised between the height H1 of the inlet section 10A and said minimum level L1 can overflow into the second tank 10;
d) filling the first tank 8 with the washing liquid to be treated to reach said predetermined minimum filling level L1, wherein such filling is implemented with the barrier means 12 in said closing position;
e) keeping, at the end of said step d), the washing liquid in a resting condition for a first predetermined interval of time, allowing the surfacing of the monomer (or polymer) contained in the liquid and the decanting of the water under the surfaced monomer (or polymer);
f) displacing said barrier means to said opening position to allow the overflowing of said liquid volume into said second tank 10.

The method indicated above thus makes it possible to isolate a volume of liquid in the second tank 10 which will be advantageously smaller than the volume of liquid remaining in the first tank 8 and in which the surfaced monomer (or polymer) will be contained.

Preferably, the method according to the invention may also include the steps of:
g) keeping the washing liquid overflown into the second tank 10 in a resting condition for another predetermined interval of time to allow the surfacing of the monomer (or polymer) contained in the liquid and the decanting of the water under the surfaced monomer (or polymer);
h) taking, from the second tank 10, part of the decanted water in step e) and pouring such water back into the first tank 8, and
i) taking the residual mixture remaining in the second tank 10 following step h) and subjecting said residual mixture to a distillation process to separate the monomer (or polymer) and obtain distilled water.

Advantageously, the water distilled in step i) may be poured back to the first tank 8.

Figures 5 and 6 are diagrammatic views of possible embodiments of a washing station 50 according to the invention, which in all cases comprises a washing chamber 55 in which a flexographic plate 52 is treated. Brushing means are arranged inside this chamber 55, which allow the brushing of the plate 52. Such brushing means may vary according to the washing method provided for the plate. In the washing station 50 diagrammatically shown in Figure 5, for example, the plate 52 is arranged about a cylinder 59 which may rotate about a respective rotation axis. The brushing means comprise rotating brushes 56, the rotation axis of which is parallel to that of the cylinder 59.

Instead, in the embodiment diagrammatically shown in Figure 6, the plate 52 moves on a plane defined by moving rollers 53. Also in this case, the brushing means may comprise rotating brushes 56 or alternatively brushes which translate on a plane parallel to that of movement of the plate 52.

In the washing station 50, the treatment unit 100 is arranged preferably in a position under the washing chamber 55. During the normal operation of the washing station 50, the first tank 8 acts as reservoir containing the washing liquid used in the chamber 55. With this regard, a hydraulic line 350, which connects the first tank 8 to the hydraulic terminals 88 arranged in the chamber 55 and through which the washing liquid exits, is arranged. Preferably, such hydraulic terminals 88 are arranged near the brushes 56 acting on the plate 52. Circulation along the hydraulic line 350 is guaranteed by a further circulation pump 13. As diagrammatically shown in figures 5 and 6, the circulation line 350 may comprise a plurality of branches 351,352, each of which to take the washing liquid to a corresponding hydraulic terminal 88.

With reference to the diagrammatic view in Figure 5, the first hydraulic line 91 shown above may comprise a plurality of branches 98 to take running water at corresponding hydraulic terminal 89 to inside the chamber 55, e.g. at further rinsing brushes 56B and/or drying brushes 56C. Each of these branches 98 may comprise a valve 99 to allow the running water flow to the corresponding hydraulic terminal 89 or not.

Inside it, the chamber 55 may preferably also comprise a washing water collection structure, indicated by reference numeral 57 in Figures 5 and 6. Such collection structure will convey the washing liquid, which will be discharged into the first tank 8 of the treatment unit 100, as shown by the arrow F again in Figures 5 and 6. The operation of the washing station 50 is managed by a control unit ECU in which the module ECM which manages the components of the treatment unit 100 may be advantageously integrated. In other words, the operation of the treatment unit 100 is managed by the same unit used for controlling the means which implement the washing of the plate 52. The control unit ECU containing the module ECM is indicated in Figures 5 and 6. Also in this case, the electrical connections which connect the control unit to the components of the washing station 50 and/or of the treatment unit 100 are not shown.

The washing station 50 according to the invention may be provided with the entire treatment assembly 300 according to the invention and thus also comprises the distillation unit 200 indicated above. The latter may be arranged in a position either adjacent to the chamber 55 or not. In all cases, the second branch line 301B will make the second tank 10 and/or the first tank 8 hydraulically communicating with the distillation unit 200.

The operation of the treatment unit 100 considered integrated in a washing station 50 is explained below according to the diagrammatic views shown in Figures 5 and 6. During the washing of the plates 52, the barrier 12 keeps the closing position and the two tanks 8, 10 of the unit itself are physically separated in the treatment unit 100.

The control unit ECU of the washing station 50 detects the number of plates 52 which are processed in the chamber 55. After the washing of a given number of plates, said ECU indicates the need to start the washing water treatment procedure, i.e. to eliminate the monomer (or polymer) from the liquid itself. After this indication, the washing station 50 will not accept the introduction of further plates and the operator will start the treatment procedure.

The first sensor means 9 detect the liquid level in the first tank 8. If such level is under the predetermined minimum level L1, the ECU controls the opening of the adjustment valve 14. Feeding with running water continues until such minimum level L1 is reached.

Having reached this condition, the liquid in the first tank 8 is made to rest for a first predetermined interval of time, e.g. 30 minutes. In this interval of time, the monomer (or the polymer) surfaces towards the top, while the water part decants under the surfaced monomer (or polymer). So, the two phases F1 and F2, defined above, are formed in this interval of time.

At the end of the first interval of time, the ECU sends a control signal to the moving means (e.g. in form of actuators) of the barriers 12, following which the barrier 12 moves from the closing position to the opening position, starting the overflowing of the liquid from the first tank 8 to the second tank 10. The water conveys the monomer (or polymer) into the second tank 10 until the overflowing ends, i.e. until the level of liquid in the first tank 8 reaches the height of the inlet section 10A, i.e. the height of the upper edge 102A of the side containing structure 102.

Having reached such condition, detected by the first sensor means, the ECU instructs said moving means to close of the barriers 12. At this point, the liquid overflown into the second tank 10 is kept in a resting condition to allow the monomer (or polymer) to surface again. In this manner, in the second tank 10 the first phase F1*, constituted substantially of water, and a second phase F2*, over the first because lighter, comprising the surfaced water-soaked monomer (or polymer), are recomposed.

At the end of this second interval, the ECU sends a control signal to the discharge valve 17 and to the first shut-off valve 16, after which such valves open. Conversely, the second valve 29 and the third valve 18 remain closed. At the same time, the ECU activates the first circulation pump 15. This condition activates the first step of discharging of the second tank 10, by effect of which a fraction of the decanted water (i.e. part of the first phase F1*) is returned to the first tank 10, exploiting the first branch 301A indicated above.

When the liquid in the second tank 10 reaches a second predetermined level L2, detected by means of the second sensor means 11, the ECU controls the closing of the first shut-off valve 16 and the opening of the second shut-off valve 29. In this manner, a second step of discharging is actuated, during which the residual mixture, remained in the second tank 10, is sent to the distillation unit 20 along the second hydraulic branch 301B.

Such residual mixture is mainly composed of monomer (or polymer), and by a much lower residual volume of water with respect to that previously overflown into the second tank 10 by effect of the first step of discharging. In this manner, the recovery of the water and of the distillation of water in the distillation unit 200 is fast and inexpensive. With this regard, a smaller size distillation unit 200 compared to those traditionally used in the known systems for treating the washing liquid may be used.

At the end of the emptying of the second tank 10, the ECU controls the closing of the discharge valve 17 and the stopping of the first circulation pump 15. At the end of the distillation process, the ECU controls the actuation of the second circulation pump 26 and the opening of the shut-off valve 27 arranged along the feeding line 302. In this manner, the distilled water collected in the container 25 is sent to the first tank 8 of the treatment unit 100.

From the description of the operation shown above, it is apparent that all the water overflown into the second tank 10 is advantageously returned to the first tank 8 of the treatment unit 100 to be then reused in the washing station 50 for washing another series of plates. This aspect translates into a considerable containment of the liquid/water volumes needed for the operation of the machine, with obvious advantages in terms of economy and environment impact.

As mentioned above, when the washing station 50 is not used, e.g. at the end of shift or during the night, the operator may advantageously start, via the ECU, a distillation procedure of the washing liquid collected in a first tank 8. In order to activate such procedure, the ECU controls the opening of the second discharge valve 18 and the second shut-off valve 29 and the concurrent activation of the first circulation pump 15. The first discharge valve 17 and the first shut-off valve 16 are kept closed. The washing liquid contained in the first tank 8 is thus pumped directly towards the distillation unit 300 through the second discharging line 321 and the second branch 301B.

Preferably, in the scope of this distillation procedure, the first pump 15 is preferably activated at intervals of time. Substantially, the first pump 15 is activated for a certain time and successively deactivated until the pumped liquid has been completely distilled and collected in the container 25. At this point, the first pump 15 is reactivated again so as to pump a second liquid volume into the second treatment unit.

Again with reference to such distillation procedure, once the container 25 is full of distilled water, the ECU controls the opening of the third shut-off valve 27 e the activation of the second pump 26 so as to transfer the distilled liquid back into the first tank 8. Appropriate sensor means are arranged to provide information concerning the water level reached in the container 25 to the ECU. Advantageously, at the end of the distillation procedure described above, the liquid contained in the first tank 10 will be substantially regenerated, i.e. cleaned from the monomer (or polymer). As a whole, it is worth noting that by means of the treatment unit 100, and more in general by means of the treatment assembly 300, the water part contained in the washing liquid is continuously and advantageously recovered with obvious advantages in terms of consumption. Losses of load are reabsorbed by means of the first feeding line 301 indicated above.

The described technical solutions allow to fully achieve the predetermined tasks and objects. In particular, the treatment unit according to the invention makes it possible to separate the monomer (or polymer) contained in the water-based washing liquid without using mechanical filters. Concurrently, the washing station according to the invention advantageously makes it possible to recycle the washing liquid water, minimizing the liquid volumes to be managed. This aspect is very advantageous in economic terms.

## Claims

1. A washing station (50) for washing flexographic plates (52) with water-based washing liquid, wherein said washing station (50) comprises:
- a chamber (55) in which said plates (52) are treated;
- brushing means (56, 56B, 56C) for brushing said plates (52) arranged in said chamber;
- a treatment unit (100) for treating the water-based washing liquid used in or by the washing station (50), wherein said washing liquid comprises some monomer or polymer detached from said plates (52) during their washing, the treatment unit (100) comprising:
- a first tank (8) for collecting said washing liquid to a predetermined minimum filling level (L1), said monomer or said polymer surfacing in said first tank (8) after said liquid rests for a predetermined interval of time;
- a second tank (10) for collecting said monomer or said polymer surfaced in said first tank (8), wherein said second tank (10) comprises an inlet section (10A) arranged at a lower height (H1) than said minimum filling level (L1) of said first tank (8),
**characterized in that**
- said first tank (8) and said second tank (10) of the treatment unit (100) are arranged outside said chamber (55);
- the treatment unit (100) comprises barrier means (12), movable between a closing position, in which said barrier means (12) prevent the communication between said first tank (8) and said second tank (10) and an opening position, by effect of which said two tanks (8,10) become communicating so that at least said monomer or said polymer surfaced in said first tank (8) can overflow into said second tank (10);
- the washing station (50) comprises a hydraulic distribution line (350) comprising at least one circulation pump (13) which hydraulically connects said first tank (8) of said treatment unit (100) to hydraulic terminals (88) inside said chamber (55), from which said washing liquid may exit.

2. A washing station (50) according to claim 1, wherein each of said tanks (8,10) comprises a bottom wall (81,101) and a side containing structure (82,102) defining a respective upper edge of the tanks (8, 10), wherein said side containing structure (102) of said second tank (10) delimits a volume which is either inside or outside the volume defined by the side containing structure (82) of said first tank (8).

3. A washing station (50) according to claim 1 or 2, wherein said barrier means comprise at least one barrier (12) which can be turned or translated, in reversible manner, between said closing position and said opening position.

4. A washing station (50) according to any one of the claims from 1 to 3, wherein said unit (100) is provided with moving means (90) for moving, in reversible manner, said barrier means (12) between said closing position and said opening position.

5. A washing station (50) according to any one of the claims from 1 to 4, wherein said treatment unit comprises sensor means (9) for detecting the liquid level in said first tank (8) and/or second sensor means (11) to detect the liquid level in said second tank (10).

6. A washing station (50) according to any one of the claims from 1 to 5, wherein said unit (100) comprises a first hydraulic feeding line (91), which makes said first tank (8) connectable to a running water source (28).

7. A washing station (50) according to any one of the claims from 1 to 6, wherein said unit (100) comprises a discharge line (301) for discharging the liquid which has overflown into said second tank (10), said discharge line (301) comprising a first circulation pump (15) and a discharge valve (17) upstream of said first pump (15).

8. A washing station (50) according to claim 7, wherein said unit (100) comprises a first hydraulic branch (301A), downstream of said first pump (15), said first branch (301A) comprising a first shut-off valve (16), which in opening condition allows the hydraulic communication between said second tank (10) and said first tank (8).

9. A washing station (50) according to claim 7 or 8, wherein said unit (100) comprises a second hydraulic branch (301B), downstream of said first pump (15), said second branch (301B) connecting said second tank (10) to a distillation unit (200), said second branch (301B) comprising a second shut-off valve (29), which in an opening condition makes said second tank (10) hydraulically communicate with said distillation unit (200).

10. A washing station (50) according to any one of the claims from 7 to 9, wherein said unit (100) comprises a second discharge line (321), which connects said first tank (8) to said first discharge line (301), upstream of said first circulation pump (15), said second discharge line (321) comprising a second discharge valve (18) which, in an opening condition, makes it possible to discharge the liquid contained in said first tank (8).

11. A washing station (50) according to any one of the previous claims comprising an assembly (300) for treating the water-based washing liquid used in the washing station (50), said assembly (300) comprising:
- said treatment unit (100);
- a distillation unit (200) for separating said monomer or said polymer contained in said liquid and for retrieving the water part of said liquid.

12. A washing station (50) according to claim 11, wherein said distillation unit (200) comprises a distillation module (24) and a container (25) for collecting distilled water and wherein said assembly (300) comprises a further feeding hydraulic line (302), which connects said container (25) to said first tank (8) of said treatment unit (100), said further hydraulic line (302) comprising a further circulation pump (26) and a further shut-off valve (27) which, in an opening condition, allows the transfer of said water contained in said container (25) into said first tank (8).

13. A method for treating water-based liquid used in a washing station (50) of flexographic plates (52) comprising a chamber (55) in which said plates (52) are treated, wherein said method includes the steps of:
a) providing a first tank (8) and a second tank (10) outside said chamber (55) for collecting said liquid, wherein said second tank (10) comprises an inlet section (10A);
b) arranging said second tank (10) with respect to said first tank (8) so that said inlet section (10A) is at a lower height (H1) than a predetermined minimum level (L1) for said liquid inside said first tank (8);
c) providing, between said tanks (8,10), barrier means (12) configured to assume a closing position, after which said tanks (8,10) are not communicating, and an opening position, after which the liquid volume of said first tank (8) comprised between said height (H1) of said inlet section and said minimum level (L1) overflows into said second tank (10);
d) filling the first tank (8) with said washing liquid to be treated to reach said minimum filling level (L1), said filling being actuated with said barrier means (12) in said closing position;
e) keeping, following said step d), the washing liquid in a resting condition for a first predetermined interval of time to allow the surfacing of the monomer or of the polymer contained in the liquid and the decanting of the water under the surfaced monomer or polymer;
f) displacing said barrier means (12) in said opening position to allow said liquid volume to overflow into said second tank (10) so that said monomer or said polymer surfaced in step e) is collected in said second tank (10).

14. A method according to claim 13, wherein said method further comprises the steps of:
g) keeping the overflown liquid in said second tank (10) in a resting condition for another predetermined interval of time to allow the surfacing of said monomer or of said polymer contained in said overflown liquid and the decanting of the respective water part the surfaced monomer and polymer;
h) taking, from said second tank (10), a volume of said decanted water in step g) and pouring such volume back into said first tank (8), and
i) taking the residual mixture remaining in said second tank (10) following step h) and subjecting said residual mixture to a distillation process to separate said monomer or said polymer and obtain distilled water.

## Patentansprüche

1. Waschstation (50) zum Waschen von Flexodruckplatten (52) mit einer wasserbasierten Waschflüssigkeit, wobei die Waschstation (50) Folgendes umfasst:
- eine Kammer (55), in der die Platten (52) behandelt werden;
- Bürstmittel (56, 56B, 56C) zum Bürsten der in der Kammer angeordneten Platten (52);
- eine Behandlungseinheit (100) zum Behandeln der wasserbasierten Waschflüssigkeit, die in oder durch die Waschstation (50) verwendet wird, wobei die Waschflüssigkeit etwas Monomer oder Polymer umfasst, das von den Platten (52) während ihres Waschens abgelöst wird, wobei die Behandlungseinheit (100) umfasst:
- einen ersten Tank (8) zum Sammeln der Waschflüssigkeit bis zu einem vorbestimmten minimalen Füllstand (L1), wobei das Monomer oder das Polymer in dem ersten Tank (8) auftaucht, nachdem die Flüssigkeit für ein vorbestimmtes Zeitintervall ruht;
- einen zweiten Tank (10), zum Sammeln des in dem ersten Tank (8) aufgetauchten Monomers oder Polymers, wobei der zweite Tank (10) einen ersten Einlassabschnitt (10A) umfasst, der in einer geringeren Höhe (H1) als der minimale Füllstand (L1) des ersten Tanks (8) angeordnet ist,
**dadurch gekennzeichnet, dass**
- der erste Tank (8) und der zweite Tank (10) der Behandlungseinheit (100) außerhalb der Kammer (55) angeordnet sind;
- die Behandlungseinheit (100) Sperrmittel (12) umfasst, die zwischen einer Schließposition, in der die Sperrmittel (12) die Verbindung zwischen dem ersten Tank (8) und dem zweiten Tank (10) verhindern, und einer Öffnungsposition bewegbar sind, durch welche die zwei Tanks (8,10) miteinander in Verbindung gebracht werden, sodass zumindest das Monomer oder das Polymer, das in dem ersten Tank (8) aufgetaucht ist, in den zweiten Tank (10) überlaufen kann;
- die Waschstation (50) eine hydraulische Verteilungsleitung (350) umfasst, die mindestens eine Umwälzpumpe (13) umfasst, die den ersten Tank (8) der Behandlungseinheit (100) hydraulisch mit hydraulischen Anschlüssen (88) innerhalb der Kammer (55) verbindet, aus der die Waschflüssigkeit austreten kann.

2. Waschstation (50) nach Anspruch 1, wobei jeder der Tanks (8, 10) eine untere Wand (81, 101) und eine seitenhaltige Struktur (82, 102) umfasst, die einen jeweiligen oberen Rand der Tanks (8, 10) definiert, wobei die seitenhaltige Struktur (102) des zweiten Tanks (10) ein Volumen begrenzt, das entweder innerhalb oder außerhalb des Volumens liegt, das durch die seitenhaltige Struktur (82) des ersten Tanks (8) definiert ist.

3. Waschstation (50) nach Anspruch 1 oder 2, wobei die Sperrmittel mindestens eine Sperre (12) umfassen, die auf reversible Art und Weise zwischen der Schließposition und der Öffnungsposition gedreht und verschoben werden kann.

4. Waschstation (50) nach einem der Ansprüche 1 bis 3, wobei die Einheit (100) mit Bewegungsmitteln (90) zum Bewegen der Sperrmittel (12) auf reversible Art und Weise zwischen der Schließposition und der Öffnungsposition versehen ist.

5. Waschstation (50) nach einem der Ansprüche 1 bis 4, wobei die Behandlungseinheit Sensormittel (9) zum Erfassen des Flüssigkeitsstands in dem ersten Tank (8) und/oder zweite Sensormittel (11) zum Erfassen des Flüssigkeitsstands in dem zweiten Tank (10) umfasst.

6. Waschstation (50) nach einem der Ansprüche 1 bis 5, wobei die Einheit (100) eine erste hydraulische Zufuhrleitung (91) umfasst, die den ersten Tank (8) mit einer Fließwasserquelle (28) verbindbar macht.

7. Waschstation (50) nach einem der Ansprüche 1 bis 6, wobei die Einheit (100) eine Auslassleitung (301) zum Auslassen der in den zweiten Tank (10) übergelaufenen Flüssigkeit umfasst, wobei die Auslassleitung (301) eine erste Umwälzpumpe (15) und ein Auslassventil (17) stromaufwärts von der ersten Pumpe (15) umfasst.

8. Waschstation (50) nach Anspruch 7, wobei die Einheit (100) eine erste hydraulische Verzweigung (301A) stromabwärts von der ersten Pumpe (15) umfasst, wobei die erste Verzweigung (301A) ein erstes Absperrventil (16) umfasst, das im Öffnungszustand hydraulische Verbindung zwischen dem zweiten Tank (10) und dem ersten Tank (8) ermöglicht.

9. Waschstation (50) nach Anspruch 7 oder 8, wobei die Einheit (100) eine zweite hydraulische Verzweigung (301B) stromabwärts von der ersten Pumpe (15) umfasst, wobei die zweite Verzweigung (301B) den zweiten Tank (10) mit einer Destillationseinheit (200) verbindet, wobei die zweite Verzweigung (301B) ein zweites Absperrventil (29) umfasst, das in einem Öffnungszustand den zweiten Tank (10) hydraulisch mit der Destillationseinheit (200) verbindet.

10. Waschstation (50) nach einem der Ansprüche 7 bis 9, wobei die Leitung (100) eine zweite Auslassleitung (321) umfasst, die den ersten Tank (8) stromaufwärts von der ersten Umwälzpumpe (15) mit der ersten Auslassleitung (301) verbindet, wobei die zweite Auslassleitung (321) ein zweites Auslassventil (18) umfasst, das es in einem Öffnungszustand ermöglicht, die in dem ersten Tank (8) enthaltene Flüssigkeit auszulassen.

11. Waschstation (50) nach einem der vorstehenden Ansprüche, umfassend eine Anordnung (300) zur Behandlung der in der Waschstation (50) verwendeten wasserbasierten Waschflüssigkeit, wobei die Anordnung (300) umfasst:
- die Behandlungseinheit (100);
- eine Destillationseinheit (200) zur Abtrennung des in der Flüssigkeit enthaltenen Monomers oder Polymers und zur Rückgewinnung des Wasseranteils der Flüssigkeit.

12. Waschstation (50) nach Anspruch 11, wobei die Destillationseinheit (200) ein Destillationsmodul (24) und einen Behälter (25) zum Sammeln von destilliertem Wasser umfasst und wobei die Anordnung (300) eine weitere hydraulische Zufuhrleitung (302) umfasst, die den Behälter (25) mit dem ersten Tank (8) der Behandlungseinheit (100) verbindet, wobei die weitere hydraulische Leitung (302) eine weitere Umwälzpumpe (26) und ein weiteres Absperrventil (27) umfasst, das in einem Öffnungszustand die Übertragung des in dem Behälter (25) enthaltenen Wassers in den ersten Tank (8) ermöglicht.

13. Verfahren zur Behandlung einer wasserbasierten Flüssigkeit, die in einer Waschstation (50) für Flexodruckplatten (52) verwendet wird, die eine Kammer (55) umfasst, in der die Platten (52) behandelt werden, wobei das Verfahren die folgenden Schritte einschließt:
a) Bereitstellen eines ersten Tanks (8) und eines zweiten Tanks (10) außerhalb der Kammer (55) zum Sammeln der Flüssigkeit, wobei der zweite Tank (10) einen Einlassabschnitt (10A) umfasst;
b) Anordnen des zweiten Tanks (10) in Bezug auf den ersten Tank (8), sodass sich der Einlassabschnitt (10A) in einer geringeren Höhe (H1) als ein vorbestimmter minimaler Stand (L1) für die Flüssigkeit innerhalb des ersten Tanks (8) befindet;
c) Bereitstellen von Sperrmitteln (12) zwischen den Tanks (8, 10), die so konfiguriert sind, dass sie eine Schließposition, nach der die Tanks (8, 10) nicht miteinander in Verbindung stehen, und eine Öffnungsposition einnehmen, nach der das Flüssigkeitsvolumen des ersten Tanks (8), das zwischen der Höhe (H1) des Einlassabschnitts und dem minimalen Stand (L1) umfasst ist, in den zweiten Tank (10) überläuft;
d) Füllen des ersten Tanks (8) mit der zu behandelnden Waschflüssigkeit, um den minimalen Füllstand (L1) zu erreichen, wobei das Füllen mit den Sperrmitteln (12) in der Schließposition durchgeführt wird;
e) Halten der Waschflüssigkeit nach dem Schritt d) in einem Ruhezustand für ein erstes vorbestimmtes Zeitintervall, um das Auftauchen des in der Flüssigkeit enthaltenen Monomers oder des Polymers und das Dekantieren des Wassers unter dem aufgetauchten Monomer oder Polymer zu ermöglichen;
f) Verschieben der Sperrmittel (12) in die Öffnungsposition, um ein Überlaufen des Flüssigkeitsvolumens in den zweiten Tank (10) zu ermöglichen, sodass sich das in Schritt e) aufgetauchte Monomer oder Polymer in dem zweiten Tank (10) sammelt.

14. Verfahren nach Anspruch 13, wobei das Verfahren weiter die folgenden Schritte umfasst:
g) Halten der übergelaufenen Flüssigkeit in dem zweiten Tank (10) in einem Ruhezustand für ein weiteres vorbestimmtes Zeitintervall, um das Auftauchen des in der übergelaufenen Flüssigkeit enthaltenen Monomers oder des Polymers und das Dekantieren des jeweiligen Wasseranteils des aufgetauchten Monomers und Polymers zu ermöglichen;
h) Entnehmen eines Volumens des in Schritt g) dekantierten Wassers aus dem zweiten Tank (10) und Zurückgießen dieses Volumens in den ersten Tank (8), und
i) Entnehmen des in dem zweiten Tank (10) nach Schritt h) verbleibenden Restgemisches und Unterziehen des Restgemisches einem Destillationsprozess, um das Monomer oder das Polymer abzutrennen und destilliertes Wasser zu erhalten.

## Revendications

1. Station de lavage (50) pour nettoyer des plaques flexographiques (52) avec du liquide de lavage à base d'eau, dans laquelle ladite station de lavage (50) comprend :
- une chambre (55) dans laquelle lesdites plaques (52) sont traitées ;
- un moyen de brossage (56, 56B, 56C) pour brosser lesdites plaques (52) agencées dans ladite chambre ;
- une unité de traitement (100) pour traiter le liquide de lavage à base d'eau utilisé dans ou par la station de lavage (50), dans laquelle ledit liquide de lavage comprend un certain monomère ou polymère détaché desdites plaques (52) durant leur lavage, l'unité de traitement (100) comprenant :
- un premier réservoir (8) pour collecter ledit liquide de lavage vers un niveau de remplissage minimal prédéterminé (L1), ledit monomère ou ledit polymère remontant à la surface dans ledit premier réservoir (8) après que ledit liquide a reposé pendant un intervalle de temps prédéterminé ;
- un second réservoir (10) pour collecter ledit monomère ou ledit polymère ayant remonté à la surface dans ledit premier réservoir (8), dans lequel ledit second réservoir (10) comprend une section d'entrée (10A) agencée à une hauteur (H1) inférieure audit niveau de remplissage minimal (L1) dudit premier réservoir (8),
**caractérisé en ce que**
- ledit premier réservoir (8) et ledit second réservoir (10) de l'unité de traitement (100) sont agencés à l'extérieur de ladite chambre (55) ;
- l'unité de traitement (100) comprend un moyen de barrière (12), mobile entre une position de fermeture, dans laquelle ledit moyen de barrière (12) empêche la communication entre ledit premier réservoir (8) et ledit second réservoir (10), et une position d'ouverture, par l'effet de laquelle lesdits deux réservoirs (8, 10) communiquent de sorte qu'au moins ledit monomère ou ledit polymère ayant remonté à la surface dans ledit premier réservoir (8) puisse déborder dans ledit second réservoir (10) ;
- la station de lavage (50) comprend une ligne de distribution hydraulique (350) comprenant au moins une pompe de circulation (13) qui raccorde de manière hydraulique ledit premier réservoir (8) de ladite unité de traitement (100) à des bornes hydrauliques (88) à l'intérieur de ladite chambre (55), depuis lesquelles ledit liquide de lavage peut sortir.

2. Station de lavage (50) selon la revendication 1, dans laquelle chacun desdits réservoirs (8, 10) comprend une paroi inférieure (81, 101) et une structure de contenant latérale (82, 102) définissant un bord supérieur respectif des réservoirs (8, 10), dans laquelle ladite structure de contenant latérale (102) dudit second réservoir (10) délimite un volume qui est soit à l'intérieur soit à l'extérieur du volume défini par la structure de contenant latérale (82) dudit premier réservoir (8).

3. Station de lavage (50) selon la revendication 1 ou 2, dans laquelle ledit moyen de barrière comprend au moins une barrière (12) qui peut être tournée ou translatée, de manière réversible, entre ladite position de fermeture et ladite position d'ouverture.

4. Station de lavage (50) selon l'une quelconque des revendications 1 à 3, dans laquelle ladite unité (100) est pourvue d'un moyen de déplacement (90) pour déplacer, de manière réversible, ledit moyen de barrière (12) entre ladite position de fermeture et ladite position d'ouverture.

5. Station de lavage (50) selon l'une quelconque des revendications 1 à 4, dans laquelle ladite unité de traitement comprend un moyen de détection (9) pour détecter le niveau de liquide dans ledit premier réservoir (8) et/ou un second moyen de détection (11) pour détecter le niveau de liquide dans ledit second réservoir (10).

6. Station de lavage (50) selon l'une quelconque des revendications 1 à 5, dans laquelle ladite unité (100) comprend une première d'alimentation hydraulique (91), qui rend ledit premier réservoir (8) raccordable à une source d'eau courante (28).

7. Station de lavage (50) selon l'une quelconque des revendications 1 à 6, dans laquelle ladite unité (100) comprend une ligne d'évacuation (301) pour évacuer le liquide qui a débordé dans ledit second réservoir (10), ladite ligne d'évacuation (301) comprenant une première pompe de circulation (15) et une soupape d'évacuation (17) en amont de ladite première pompe (15).

8. Station de lavage (50) selon la revendication 7, dans laquelle ladite unité (100) comprend une première branche hydraulique (301A), en aval de ladite première pompe (15), ladite première branche (301A) comprenant une première soupape d'arrêt (16), qui, en état d'ouverture, permet la communication hydraulique entre ledit second réservoir (10) et ledit premier réservoir (8).

9. Station de lavage (50) selon la revendication 7 ou 8, dans laquelle ladite unité (100) comprend une seconde branche hydraulique (301B), en aval de ladite première pompe (15), ladite seconde branche (301B) raccordant ledit second réservoir (10) à une unité de distillation (200), ladite seconde branche (301B) comprenant une seconde soupape d'arrêt (29), qui, en état d'ouverture, fait communiquer de manière hydraulique ledit second réservoir (10) avec ladite unité de distillation (200).

10. Station de lavage (50) selon l'une quelconque des revendications 7 à 9, dans laquelle ladite unité (100) comprend une seconde ligne d'évacuation (321), qui raccorde ledit premier réservoir (8) à ladite première ligne d'évacuation (301), en aval de ladite première pompe de circulation (15), ladite seconde ligne d'évacuation (321) comprenant une seconde soupape d'évacuation (18), qui, en état d'ouverture, rend possible d'évacuer le liquide contenu dans ledit premier réservoir (8).

11. Station de lavage (50) selon l'une quelconque des revendications précédentes, comprenant un ensemble (300) pour traiter le liquide de lavage à base d'eau utilisé dans la station de lavage (50), ledit ensemble (300) comprenant :
- ladite unité de traitement (100) ;
- une unité de distillation (200) pour séparer ledit monomère ou ledit polymère contenu dans ledit liquide et pour extraire la partie aqueuse dudit liquide.

12. Station de lavage (50) selon la revendication 11, dans laquelle ladite unité de distillation (200) comprend un module de distillation (24) et un contenant (25) pour collecter de l'eau distillée et dans laquelle ledit ensemble (300) comprend une autre ligne d'alimentation hydraulique (302), qui raccorde ledit contenant (25) audit premier réservoir (8) de ladite unité de traitement (100), ladite autre ligne hydraulique (302) comprenant une autre pompe de circulation (26) et une autre soupape d'arrêt (27) qui, en état d'ouverture, permet le transfert de ladite eau contenue dans ledit contenant (25) dans ledit premier réservoir (8).

13. Procédé de traitement de liquide à base d'eau utilisé dans une station de lavage (50) de plaques flexographiques (52) comprenant une chambre (55) dans laquelle lesdites plaques (52) sont traitées, dans lequel ledit procédé inclut les étapes consistant à :
a) fournir un premier réservoir (8) et un second réservoir (10) à l'extérieur de ladite chambre (55) pour collecter ledit liquide, dans lequel ledit second réservoir (10) comprend une section d'entrée (10A) ;
b) agencer ledit second réservoir (10) par rapport audit premier réservoir (8) de sorte que ladite section d'entrée (10A) est à une hauteur (H1) inférieure à un niveau minimal prédéterminé (L1) pour ledit liquide à l'intérieur dudit premier réservoir (8) ;
c) fournir, entre lesdits réservoirs (8, 10), un moyen de barrière (12) configuré pour prendre une position de fermeture, après laquelle lesdits réservoirs (8, 10) ne communiquent pas, et une position d'ouverture, après laquelle le volume de liquide dudit premier réservoir (8) compris entre ladite hauteur (H1) de ladite section d'entrée et ledit niveau minimal (L1) déborde dans ledit second réservoir (10) ;
d) remplir le premier réservoir (8) avec ledit liquide de lavage à traiter pour atteindre ledit niveau de remplissage minimal (L1), ledit remplissage étant actionné avec ledit moyen de barrière (12) dans ladite position de fermeture ;
e) garder, après ladite étape d), le liquide de lavage dans un état de repos pendant un premier intervalle de temps prédéterminé pour permettre la remontée à la surface du monomère ou du polymère contenu dans le liquide et la décantation de l'eau sous le monomère ou polymère ayant remonté à la surface ;
f) déplacer ledit moyen de barrière (12) dans ladite position d'ouverture pour permettre audit volume de liquide de déborder dans ledit second réservoir (10) de sorte que ledit monomère ou ledit polymère ayant remonté à la surface à l'étape e) soit collecté dans ledit second réservoir (10).

14. Procédé selon la revendication 13, dans lequel ledit procédé comprend en outre les étapes consistant à :
g) garder le liquide ayant débordé dans ledit second réservoir (10) dans un état de repos pour un autre intervalle de temps prédéterminé pour permettre la remontée à la surface dudit monomère ou dudit polymère contenu dans ledit liquide ayant débordé et la décantation de la partie aqueuse respective du monomère et du polymère ayant remonté à la surface ;
h) prendre, dudit second réservoir (10), un volume de ladite eau décantée à l'étape g) et verser ce volume à nouveau dans ledit premier réservoir (8), et
i) prendre le mélange résiduel restant dans ledit second réservoir (10) après l'étape h) et soumettre ledit mélange résiduel à un processus de distillation pour séparer ledit monomère ou ledit polymère et obtenir de l'eau distillée.
